(19) Europäisches Patentamt
European Patent Office
Office européen des brevets

(11) **EP 0 406 442 B1**

(12) **EUROPEAN PATENT SPECIFICATION**

(45) Date of publication and mention
of the grant of the patent:
**17.09.1997 Bulletin 1997/38**

(51) Int Cl.⁶: **G06F 12/16**

(86) International application number:
**PCT/JP89/01277**

(21) Application number: **90901013.4**

(22) Date of filing: **19.12.1989**

(87) International publication number:
**WO 90/07155 (28.06.1990 Gazette 1990/15)**

(54) **DATA WRITE CONTROL MEANS**

DATENSCHREIBREGELUNGSMITTEL

ORGANE DE COMMANDE D'ECRITURE DE DONNEES

(84) Designated Contracting States:
**DE FR GB**

(30) Priority: **21.12.1988 JP 323055/88**

(43) Date of publication of application:
**09.01.1991 Bulletin 1991/02**

(73) Proprietors:
- **Oki Electric Industry Company, Limited
  Tokyo 105 (JP)**
- **OKI MICRO DESIGN MIYAZAKI CO. LTD
  Miyazaki 880 (JP)**

(72) Inventors:
- **ARAI, Yasuo Oki Electric Industry Co., Ltd.
  Tokyo 105 (JP)**
- **SATO, Hisatake
  Oki Micro Design Miyazaki Co.,Ltd.
  Miyazaki 880 (JP)**

(74) Representative: **Betten & Resch
Reichenbachstrasse 19
80469 München (DE)**

(56) References cited:
EP-A- 0 181 943       EP-A- 0 186 832
EP-A- 0 250 242       JP-A- 6 274 139
JP-A-61 283 939       JP-A-62 157 955

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

<u>TECHNICAL FIELD</u>

The present invention relates to a data write control means for writing data in a data holding circuit of a semiconductor memory, an electronic timer, etc. which hold the data by a backup power supply when a main power supply is broken, particularly, the data write control means having a function to prevent destruction of the stored data caused by an erroneous write signal generated at the time when the main power supply is switched to the backup power supply.

<u>BACKGROUND ART</u>

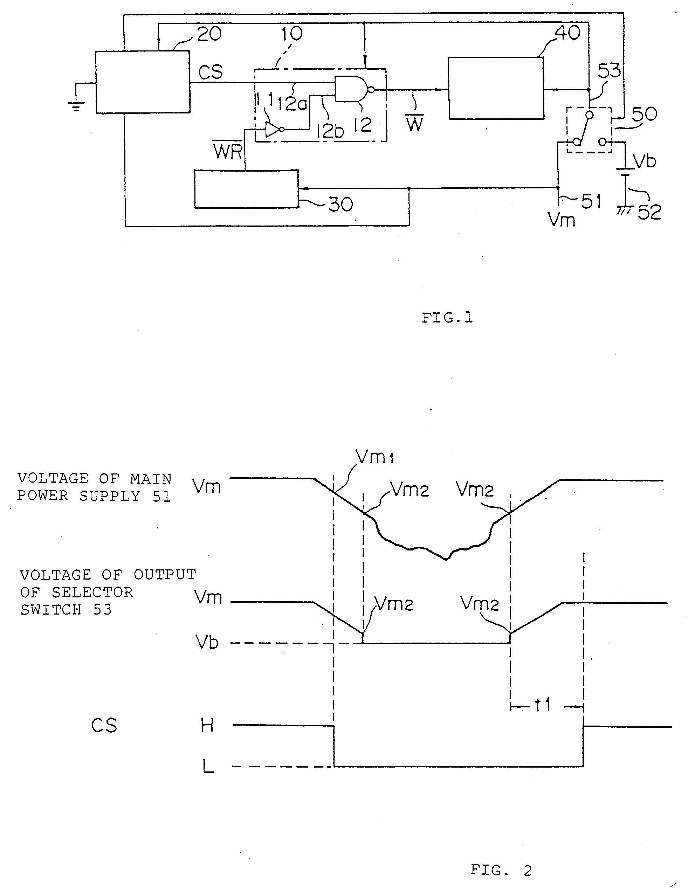

There are disclosed the data holding circuits for preventing destruction of the stored data in Japanese Patent Laid-Open Publication No. 55-23583, Utility Model Laid-Open Publication No. 57-110799, Patent Laid-Open Publication No. 58-94200, Utility Model Laid-Open Publication No. 59-84642, Patent Laid-Open Publication No. 61-283939, Utility Model Laid-Open Publication No. 62-53738, Patent Laid-Open Publication No. 63-15346 and Utility Model Laid-Open Publication No. 63-44296, an example of which will be described with reference to Fig. 1.

A data protection circuit 10 comprises an inverter 11 and a 2 input NAND gate 12. One input terminal 12a of the 2 input NAND gate 12 receives a chip select signal CS from a power supply monitoring circuit 20 and another input terminal 12b receives an external write control signal WR from a processor 30 by way of the inverter 11. Accordingly, an output of the 2 input NAND gate 12, i.e. a signal level of an internal write control signal $\overline{W}$ as an output of the data protection circuit 10 conforms to a high (H) or a low (L) signal of the external write control signal WR in the case that the chip select signal CS is a high (select) level (hereinafter referred to as H level) and is kept always at H level irrespective of the level of the external write control signal $\overline{WR}$ in the case that the chip select signal CS is low (nonselect) level (hereinafter referred to as L level).

The data holding circuit 40 receives the internal write signal $\overline{W}$ so that it becomes in a data write enable state in the case that the internal write control signal $\overline{W}$ is at L level and in a data write inhibiting state in the case that the internal write control signal $\overline{W}$ is at H level. The data holding circuit 40 receives a voltage $V_m$ from the main power supply 51 or $V_b$ from the backup power supply 52 by way of the power supply selector switch 50, hence it can hold the data on the basis of the voltage $V_b$ from a backup power supply 52 even if the main power supply 51 is broken. The voltage from the output 53 of the selector switch 50 is also supplied to the data protection circuit 10 and the power supply monitoring circuit 20. Whereupon, the voltage $V_m$ provided by the main power supply 51 is supplied to the processor 30 which is monitored by the power supply monitoring circuit 20.

An operation of the circuit set forth above will be described with reference to Fig. 2.

The power supply monitoring circuit 20 causes the chip select signal CS to be at L level when it detects that the voltage $V_m$ of the main power supply 51 reaches a first predetermined voltage $v_{m1}$. Inasmuch as the internal write control signal $\overline{W}$ as the output of the data protection circuit 10 is always kept at H level, the data holding circuit 40 is in the write inhibiting state.

The power supply monitoring circuit 20 drives the selector switch 50 to switch the main power supply 51 to the backup power supply 52 when it detects that the voltage $V_m$ of the main power supply 51 is less than a second predetermined voltage $V_{m2}$.

When the main power supply 51 is recovered, the power supply monitoring circuit 20 detects that the voltage $V_m$ of the main power supply 51 exceeds the second predetermined voltage $V_{m2}$ for thereby driving the selector switch 50 to switch to the main power supply 51 from the backup power supply 52, and thereafter provide the chip select signal CS of H level after the lapse of time t1.

With the operation set forth above, according to the circuit as illustrated in Fig. 1, the voltage exceeding the voltage $V_b$ is always supplied to the data holding circuit 40 from the output 53 of the selector switch 50 as illustrated in Fig. 2 so that the circuit can inhibit the data holding circuit 40 from writing the data therein from the time when the data holding circuit 40 detects that the voltage $V_m$ of the main power supply 51 is less than the first predetermined voltage $V_{m1}$ up to the time when the voltage $V_m$ increases to the voltage sufficient to normally drive the processor (operation assurance voltage).

However, inasmuch as the conventional data holding circuit can not detect the breakage of the main power supply until the voltage $V_m$ of the main power supply 51 is reduced to the first predetermined voltage $V_{m1}$, the data holding circuit 40 becomes in a state of write enable state when the processor 30 provides the external write control signal $\overline{WR}$ of L level during the period from the time when the main power supply is broken up to the time when the voltage $V_m$ of the main power supply is less than the first predetermined voltage $V_{m1}$ (power supply unstable period). At this state, there is a likelihood that the data is destructive when the data is written in the data holding circuit 40. Since the operation assurance voltage of the processor 30 is generally higher than the first predetermined voltage $V_{m1}$, the processor 30 is not in a normal state and liable to provide the erroneous write control signal during the power supply unstable period. Hence, the conventional holding circuit is deemed to be insufficient to protection the data with assurance.

It is an object of the present invention to provide a data write control means with an improved fail-safe characteristics.

## DISCLOSURE OF THE INVENTION

The present invention is disclosed in claims 1 and 9. Claims 2 to 8 disclose particular embodiments thereof.

## BRIEF DESCRIPTION OF THE DRAWINGS

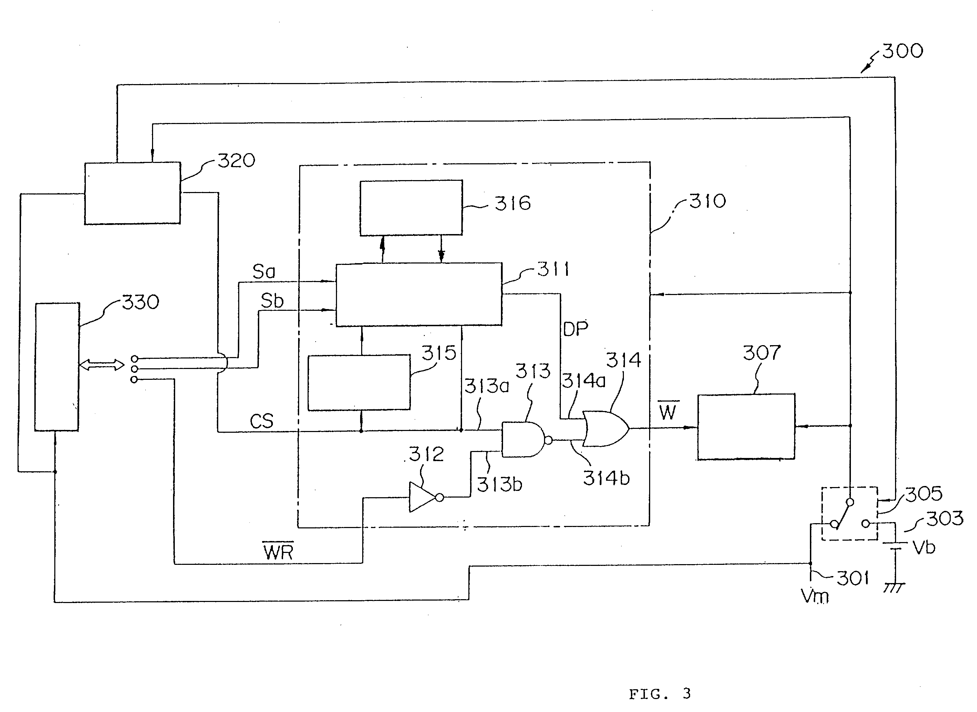

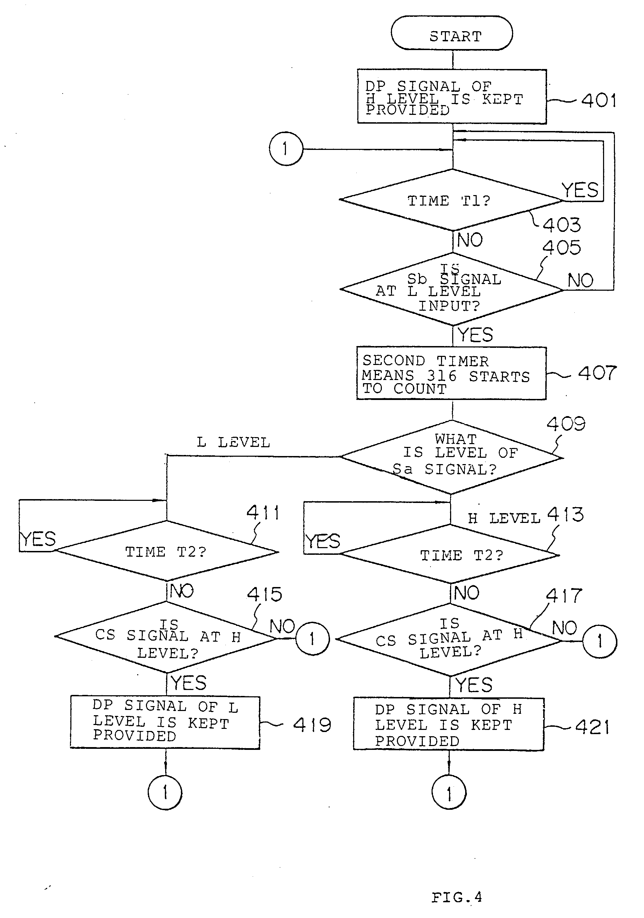

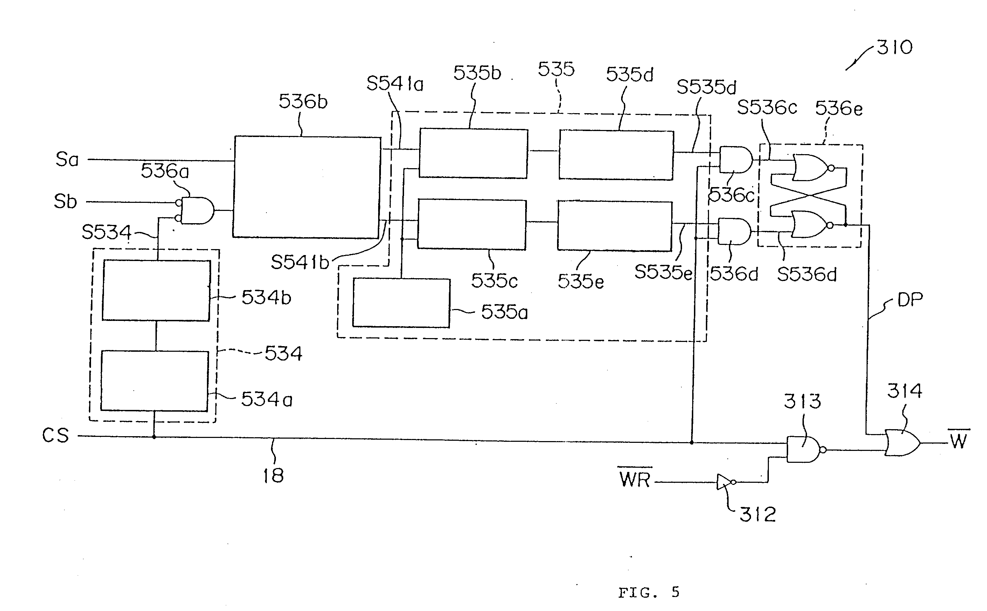

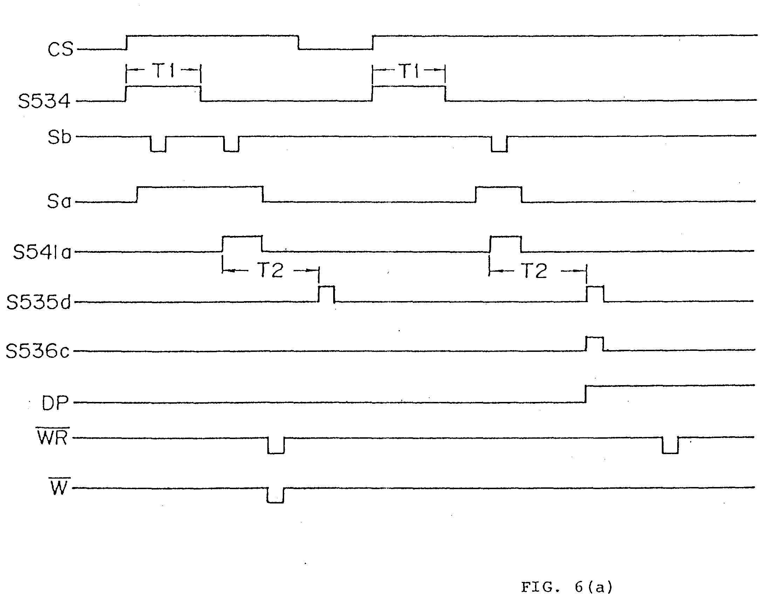

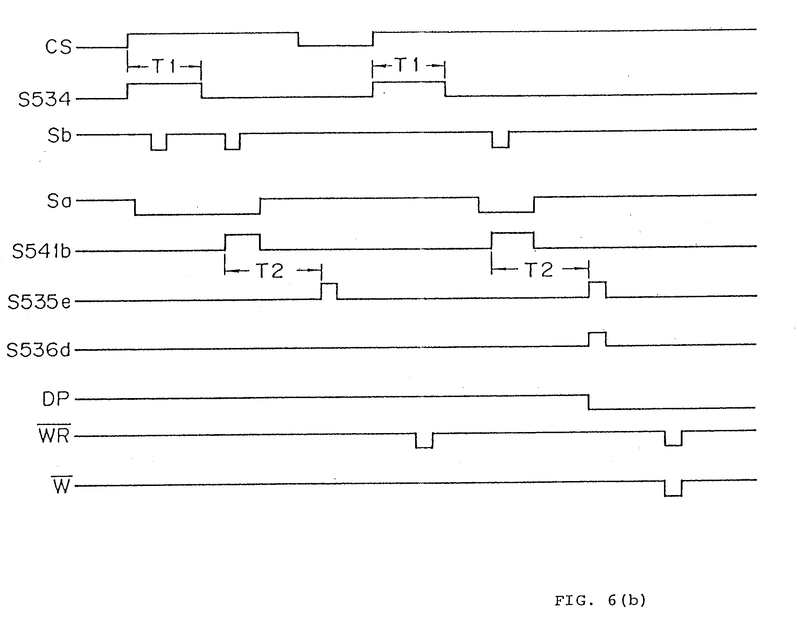

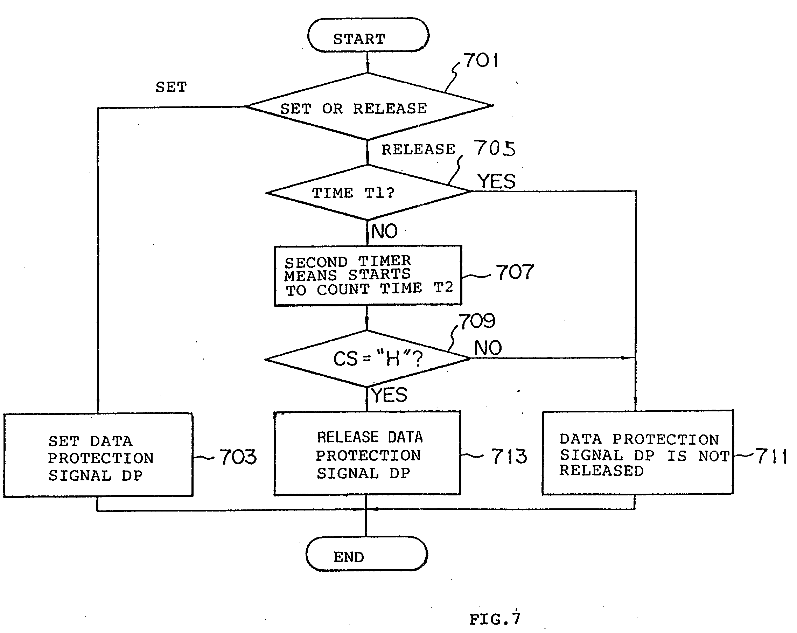

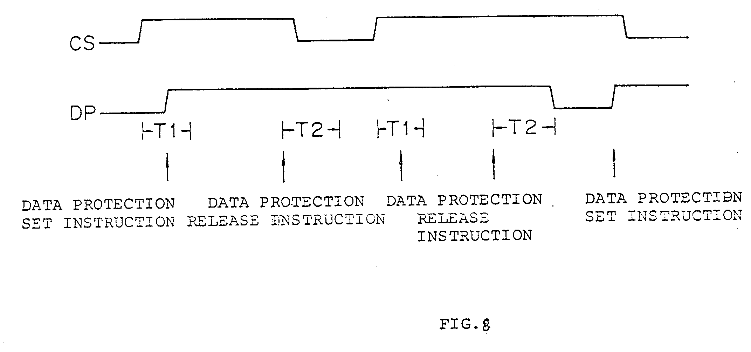

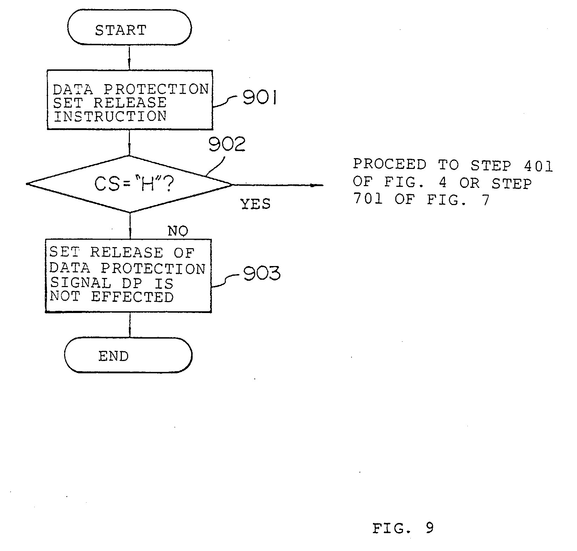

Fig. 1 is a schematic view showing a conventional data write control means, Fig. 2 is a timing diagram in a part of the circuit as illustrated in Fig. 1, Fig. 3 is schematic view of a first embodiment of the present invention, Fig. 4 is a flow chart showing a control operation of a data protection means 310 as illustrated in Fig. 3, Fig. 5 is a view explaining an arrangement of the data protection means 310 as illustrated in Fig. 3, Fig. 6a and Fig. 6b are timing diagrams showing operations of the data protection means 310 as illustrated in Fig. 5, Fig. 7 is a flow chart showing a control operation of a data protection means according to a second embodiment of the present invention, Fig. 8 is timing diagram showing an operation of the second embodiment of the present invention, and Fig. 9 is a flow chart showing a control operation of a data protection means according to a third embodiment of the present invention.

## BEST MODE FOR CARRYING OUT THE INVENTION

Fig. 3 illustrates a data write control means 300 according to a first embodiment of the present invention.

The data write control means 300 has a data holding circuit 307 to which a voltage $V_m$ of a main power supply 301 or a voltage $V_b$ of a backup power supply 303 is supplied by way of a selector switching circuit 305.

An output voltage ($V_m$ or $V_b$) of the selector switching circuit 305 is also supplied to a data protection means 310 and a power supply monitoring circuit 320. The voltage $V_m$ of the main power supply 301 is supplied to a processor 330 which is monitored by the power supply monitoring circuit 320. The power supply monitoring circuit 320 provides a chip select signal CS of a first level which is "H" level to the data protection means 310 in the case that the voltage $V_m$ of the main power supply 301 exceeds a first predetermined voltage and supplies the chip select signal CS of a second level which is "L" level to the data protection means 310 in the case that the voltage $V_m$ of the main power supply 301 is less than a first predetermined voltage. Furthermore, the power supply monitoring circuit 320 drives the selector switching circuit 305 to thereby switch the main power supply 301 to the backup power supply 303 when the voltage $V_m$ of the main power supply 301 is less than the second predetermined voltage which is lower than the first predetermined voltage in the same way as the conventional power supply monitoring circuit.

There is employed, for example, a microcomputer of Intel's 8021H as the processor 330. The microcomputer 8021H has a PORT#1 provided with pins 10 to 12 in which the pin 10 can assign a write signal Sb to a data protection circuit 311, the pin 11 can assign a data protection set release select signal Sa to the data protection circuit 311 and the pin 12 can assign a write control signal $\overline{WR}$ to an inverter 312.

The data protection means 310 comprises the inverter 312 and a 2 input NAND gate 313. An input terminal 313a of the 2 input NAND gate 313 receives the chip select signal CS (hereinafter referred to as CS signal) from the power supply monitoring circuit 320 and another input terminal 313b receives the write control signal $\overline{WR}$ from the processor 330 by way of the inverter 312. Accordingly, a level of the output signal of the 2 input NAND gate 313 conforms to an active level (L level) or an inactive level (H level) of the signal level of the write control signal $\overline{WR}$ in the case that the CS signal is at "H" level and is always at the inactive level ("H" level) irrespective of the signal level of an external write control signal $\overline{WR}$ in the case that the CS signal is at "L" level. An output of 2 input NAND gate 313 is applied to an input 314b of an OR gate 314.

The CS signal is also supplied to a first timer means 315 and the data protection circuit 311. The first timer means 315 starts to time at the rise time of the CS signal when the CS signal is varied from a second level ("L" level) to a first level ("H" level) and provides an output signal to the data protection circuit 311 after the lapse of a predetermined time T1 (e.g. 100ms) and comprises a one-shot pulse generator circuit and the like.

The data protection circuit 311 receives the data protection set release select signal Sa (hereinafter referred to as Sa signal) and a write signal Sb for writing the Sa signal (hereinafter referred to as Sb signal) from the processor 330. The Sb signal is a control signal to inhibit the data protection circuit 311 from reading the Sa signal therein or to permit reading the Sa signal therefrom. The data protection circuit 311 reads the Sa signal when the Sb signal is at "L" level and does not read the Sa signal when the Sb signal is at "H" level. Furthermore, the data protection circuit 311 does not detect that the Sb signal is at "L" level for the period during which the first timer means 315 times the predetermined period T1.

The data protection circuit 311, upon detection of the Sb signal being at "L" level, reads the Sa signal and permits the second timer means 316 to start timing of a predetermined time T2 (e.g. 50 to 200 ms). The data protection circuit 311 reads the CS signal, after completion of timing of the predetermined time T2 by the second timer means 316, and successively provides a data protection signal DP (hereinafter referred to as DP signal) of an active level ("L" level) or an inactive level ("H" level) in response to the Sa signal in case that the CS signal is at "H" level, and successively provides the DP signal provided at the time when the Sb signal is applied thereto in case that the CS signal is at "L" level. At the actuation of the data protection means 310, the level of the DP signal provided by the data protection circuit 311 can be selected at "L" or "H" and is preferable to be set at "H" level.

The OR gate 314 receives the DP signal at one input terminal 314a and an output signal of the NAND gate 313 at the other input terminal 314b and provides an "L" level signal W to the data holding circuit 307 for allowing the data holding circuit 307 to be at a write enable state only in case that both the signals are at active levels ("L" level), otherwise provides an "H" level signal $\overline{W}$ to the data holding circuit 307 for allowing the data holding circuit 307 to be at a write inhibit state.

An operation of the data protection circuit 311 will be described with reference to the flowchart as illustrated at Fig. 4.

The data protection circuit 311 successively provides the DP signal of "H" level by an actuation switch, not shown, of the data write control means 300 until it provides another DP signal (Step 401). Next, in Step 403, the data protection circuit 311 judges as to whether the first timer means times the time T1 and the program proceeds to Step 405 only in case that the first timer means completes the timing of the time T1. In Step 405, the data protection circuit 311 detects the Sb signal and the program returns to Step 403 in case that the Sb signal is at "H" level and proceeds to Step 407 in case that the Sb signal is at "L" level.

In Step 407, the data protection circuit 311 allows the second timer means 407 to start timing and detects the level of the Sa signal in Step 409 and the program proceeds to Step 411 in case that the Sa signal is at "L" level and to Step 413 in case that the Sa signal is at "H" level. In Steps 411 and 413, the data protection circuit 311 judges as to whether the second timer means 316 completes timing of the time T2 and the program proceeds to Steps 415, 417 when the data protection circuit 311 judged that the second timer means 316 completed timing.

In Step 415, the data protection circuit 311 judges as to whether the level of the CS signal is at "H" level and the program returns to Step 403 in case that the CS signal is not at "H" level and the data protection circuit 311 allows the DP signal of "L" level to be kept provided until another DP signal is provided (Step 419) in case that the CS signal is at "H" level, and the program returns to Step 403.

Meanwhile, in Step 417, the data protection circuit 311 judges as to whether the level of the CS signal is at "H" level and the program returns to Step 403 in case that the CS signal is not at "H" level and the data protection circuit 311 allows the DP signal of "H" level to be kept provided until another DP signal is provided (Step 421) in case that the CS signal is at "H" level, and the program returns to Step 403.

A concrete arrangement of the data protection means 310 of Fig. 3 will be described with reference to Fig. 5.

In the data protection means 310, a first timer means 534 comprises a rise time detecting circuit 534a for detecting the rise time of the chip select signal CS and a one-shot pulse generator 534b for generating a one-shot pulse S534 having the pulse width of the time interval T1 upon reception of the output of the rise time detecting circuit 534a. A second timer means 535 comprises an oscillator 535a for generating a pulse having a given cycle, counters 535b, 535c for receiving signals S541a, S541b to start counting the time T2 and providing output signals, and one-shot pulse generator circuits 535d, 535e for receiving the outputs of the counters 535b, 535c and providing one-shot pulses S535d, S535e each having given pulse width.

The data protection circuit 311 as illustrated in Fig. 3 comprises a NOR gate 536a, a data protection set release discriminating circuit 536b, AND gates 536c, 536d and a reset set type flip-flop (hereinafter referred to as RS-FF) 536e. The NOR gate 536a has a function to output the write signal Sb after the lapse of the predetermined time T1. The data protection set release discriminating circuit 536b receives data protection set release select signal Sa on the basis of the output of the NOR gate 536a, thereby discriminating the setting mode or the releasing mode whereby the data protection set release discriminating circuit 536b provides the signal S541a to the counter 535b in the case of setting mode and provides the signal 541b to the counter 535c in the case of relesing mode. The one-shot pulses S535d, S535e and the chip select signal CS are ANDed by the AND gates 536c, 536d which provides the set signal S536c, the reset signal S536d. The RS-FF 536e is set or reset by the set signal S536c or the reset signal 536d to provide the data protection signal DP to the OR gate 314.

An operation of the data protection circuit Fig. 5 will be described with reference to Figs. 6(a), (b). Figs. 6(a), (b) are waveforms of the operation of Fig. 5 in the setting and releasing modes of the data protection signal.

When the main power supply $V_m$ is selected, the chip select signal CS rises and the rise time detecting circuit 534a detects the rise time of the chip select signal CS and provides a detected signal to the one-shot pulse generator 534b. The one-shot pulse generator 534b, upon reception of the signal from the rise time detecting circuit 534a, provides the one-shot pulse S534 having the pulse width of the time T1 to the NOR gate 536a. The NOR gate 536a is turned off by the one-shot pulse S534. Hence, the write signal Sb input to the NOR gate 536a during the one-shot pulse S534 is output is not input to the data protection set release discriminating circuit 536b but only the data protection set release write signal Sb which is input to the data protection set release discriminating circuit 536b after the time interval T1.

The data protection set release discriminating circuit 536b receives the data protection set release select signal Sa on the basis of the output of the NOR gate 536a to discriminate the setting of the data protection (Sa = "H") or the releasing of the data protection (Sa = "L"). The data protection set release discriminating circuit 536b provides the signal S541a in the case of setting the data protection (Sa = "H") to actuate the counter 535b and provides the signal S541b as illustrated in Fig. 6(b) in the case of releasing the data protection to thereby actuate the counter 535c. The counter 535b, upon reception of the signal S541a, starts to count and provides the signal to the one-shot pulse generator circuit 535d upon completion of counting of the time T2 in response to a frequency of the oscillator 535a. Hence, the one-shot pulse generator circuit 535d provides the one-shot pulse S535d which is sufficient to set the RS-FF 536e to the AND gate 536c. Similarly, the other counter 535c, upon reception of the signal S541b, starts to count and provides the signal to the one-shot pulse generator circuit 535e upon timing the time T2 in response to a frequency of the oscillator 535a. Hence, the one-shot pulse generator circuit 535e provides the one-shot pulse S535e which is sufficient to reset the RS-FF 536e to the AND gate 536d.

Inasmuch as the AND gates 536c, 536d are turned off in the case that the chip select signal CS is at "L" level after the counter 535b or 535c counted the given time T2, the set or the release of the data protection is not effected. On the other hand, in the case that the chip select signal CS is at "H" level the RS-FF 536 is set (DP = "H") or reset (DP = "L") by the set signal S536C or the reset signal S536d by way of the AND gates 536c, 536d for thereby setting or releasing the data protection. When the data protection is set (DP = "H"), even if the write control signal WR is input to the inverter 312 the internal write control signal W is not generated (i.e. the signal $\overline{W}$ is at "H" level) but the external write signal $\overline{WR}$ is supplied as the internal write signal $\overline{W}$ to the data holding circuit 307 as illustrated in Fig. 3 only in the case that the data protection is released.

Fig. 7 is a flowchart showing an operation of the data write control means as illustrated in Fig. 2 and Fig. 8 is a timing mode of Fig. 7.

In this embodiment, an arrangement of the data protection circuit 536 as illustrated in Fig. 5 is modified in which the data protection set release signal Sa is input as it is to the data protection set release discriminating circuit 536b when the data protection set release signal Sa is at the setting instruction of the data protection (Sa = "H"). The data protection set release discriminating circuit 536b sets the data protection signal DP directly by the output thereof to "H" level for thereby setting the data protection (Steps 701, 703 in Fig. 7). That is, as far as the setting instruction of the data protection is concerned, the data protection circuit 536 immediately sets the data protection signal DP irrespective of the content of the timing (T1, T2) by the first, second timer means as illustrated in Figs. 3 and 5. In case that the releasing instruction of the data protection is executed, the program proceeds to Step 705, in case during the time interval T1 (Step 705) and in case the data protection circuit 538 judges (Step 709) the level of the CS signal after the lapse of the time interval T2 (Step 707), and the Cs signal is at "L" level, the program proceeds to Step 711 for thereby setting the data protection signal DP to "H" level. When the CS signal is judged as at "H" level in Step 709, the DP signal is released to "L" level (release) (Step 713).

In the second embodiment, the setting instruction for the data protection is excuted in a higher priority. Hence, inasmuch as the data write inhibited to be written it is possible to protect the data content by preventing the erroneous write caused by the switching of the power supply voltage variation. or noise, etc. which occur at the time other than switching of the power supply voltage so that the fail-safe effect can be improved.

Fig. 9 is the flow chart showing a data write circuit according to a third embodiment of the present invention.

In the data write circuit, the arrangement of- the data protection circuit 536 as illustrated in Fig. 5 is modified whereby when the data protection circuit 536 detects the data protection set release signal Sa (Step 901) the chip select signal CS (Step 902) is read. In case that the chip select signal CS is at "L" level, there is likelihood of occurrence of erroneous write so that the setting or releasing of the data protection is not effected (Step 903). In case that the chip select signal CS is at "H" level, the program proceeds to Step 401 as illustrated in Fig. 4 or Step 701 as illustrated in Fig. 7, and thereby operating in the same manner as the first and the second embodiments. Consequently, the processing can be simplified.

The present invention is not limited to the illustrated embodiments, for example, but can be variously modified such that the first timer means 315 as illustrated in Fig. 3 can be arranged by a counter, etc.

## CAPABILITY OF EXPLOITATION IN INDUSTRY

As mentioned in detail above, according to the present invention, the data protection set release discriminating circuit judges as to whether the data protection control signal composed of the Sa and Sb signals provided by the processor is output or not, when the processor is at an abnormal state, i.e. when the main power supply voltage is cut off, below the operating assurance voltage of the processor on the basis of the level of the chip select signal provided by the main power supply voltage monitoring circuit after the lapse of time T2. Where the breakage of the main power supply voltage is not detected after the lapse of time T2 the data protection control signal is considered to output when the processor is at a normal state, and the data protection signal is output from the data protection circuit according to the data protection control signal.

Accordingly, it is possible, according to the present invention, to protect the data holding circuit with assurance -and prevent the data holding circuit from being destructive with assurance due to erroneous write control signal.

Furthermore, according to the first embodiment of the present invention, it is possible to protect the content of the data with accuracy caused by erroneous signal generated at the time of switching the power supply voltage. Still furthermore, the data protection signal is set or released after taking a predetermined procedure so that the erroneous operation of the data protection circuit per se can be prevented.

According to the second embodiment of the present invention has an arrangement that the data protection signal is forcibly set in case that the data protection setting instruction is executed, the data is inhibitted to be written by setting the data protection signal whereby the erroneous write signal generated at the time other than the switching of the power supply voltage can be protected at its stored data, thereby improving the fail-safe.

According to the third embodiment of the present invention, setting and releasing of the data protection signal is not effected in the case that the chip select signal is at "L" level at the time of application of the data protection set release signal whereby the process can be simplified.

**Claims**

1.  A data write control system comprising:

    a switching circuit (305) selectively coupling to a main power supply (301) or a backup power supply (303) in response to a switching control signal;
    a data holding circuit (307) receiving a voltage from the main power supply (301) or the backup power supply (303) through said switching circuit (305);
    a power supply monitor (320) coupled to switching circuit (305) for producing a control signal (CS) selectively having first and second levels and the switching control signal selectively having first and second levels, the control signal (CS) having the first level when the voltage supplied through said switching circuit (305) is greater than a first predetermined level (Vm1), the control signal (CS) being changed from the first level to the second level when the voltage through said switching circuit (305) becomes lower than the first predetermined level (Vm1) and being changed from the second level to the first level after a first predetermined time (t1) when the voltage through said switching circuit (305) becomes greater than a second predetermined level (Vm2) which is lower than the first predetermined level (Vm1), the switching control signal having the first level when the voltage supplied through said switching circuit (305) is greater than a first predetermined level (Vm2), and having the second level when the voltage through said switching circuit (305) is less than or at the first predetermined level (Vm2);
a processor (330) receiving a voltage from the main power supply (301) or the backup power supply (303) through said switching circuit (305), the processor (330) generating a write control signal ($\overline{WR}$) having an active level and an inactive level; and
a data protection circuit (310) receiving a voltage from the main power supply (301) or the backup power supply (303) through said switching circuit (305), the data protection circuit (310) coupled to said data holding circuit (307), said power supply monitor (320) and said processor (330) for outputting the write control signal ($\overline{WR}$) as the internal write control signal ($\overline{W}$) to said data holding circuit (307) when the control signal (CS) has the first level;

characterized in that

said processor (330) further generates a data protection set release select signal (Sa) having an active level and an inactive level and a write signal (Sb) having an active level and an inactive level,
said data protection circuit (310) internally generates a data protection signal (DP) having a first level and a second level and outputs the write control signal ($\overline{WR}$) as the internal write control signal ($\overline{W}$) when the control signal (CS) has the first level and the data protection signal (DP) has the second level, wherein the data protection signal (DP) is changed from the second level to the first level if

(a) both of the data protection set release select signal (Sa) and the write signal (Sb) have the active level a second predetermined time (T1) after the level of the control signal (CS) is changed from the second level to the first level, and if
(b) a third predetermined time (T2) after the condition (a) is met, and the control signal (CS) has the first level,
and wherein the data protection signal (DP) is changed from the first level to the second level if
(c) the data protection set release select signal (Sa) has the inactive level and the write signal (Sb) has the active level the second predetermined time (T1) after the level of the control signal (CS) is changed from the second level to the first level, and if
(d) the third predetermined time (T2) after the condition (c) is met and the control signal (CS) has the first level.

**2.** A data write control system according to claim 1, wherein said data protection circuit (310) includes a first timer (534) outputting a first one shot pulse signal (S534) having a pulse width corresponding to the second predetermined time (T1) in response to the level change of the control signal (CS).

**3.** A data write control system according to claim 2, wherein the first timer (534) includes

a rising edge detection circuit (534a) receiving the control signal (CS) and outputting a detection signal when the control signal (CS) is changed from the second level to the first level, and
a first one shot pulse generator (534b) coupled to the rising edge detection circuit (534a) for generating the first one shot pulse signal (S534) in response to the detection signal.

**4.** A data write control system according to claim 2, wherein said data protection circuit (310) further includes a gate circuit (536a) having a first input terminal receiving the write signal (Sb), a second input terminal receiving the first one shot pulse signal (S534) and an output terminal, and the gate circuit (536a) outputs the write signal from the output terminal thereof when its second terminal does not receive the first one shot pulse signal (S534).

**5.** A data write control system according to claim 1, wherein said data protection circuit (310) includes a data protect set release discriminating circuit (536b) receiving the data protection set release select signal (Sa) and the write signal (Sb), and outputting a data protect set signal (S541a) or a data protect release signal (S541b) in response to the data protection set release select signal (Sa) and the write signal (Sb).

**6.** A data write control system according to claim 5, wherein said data protection circuit (310) further includes a data protection signal generator (535, 536c, 536d, 536e) for generating the data protection signal (DP) in response to the data protect set signal (S541a), the data protect release signal (S541b) and the control signal (CS).

**7.** A data write control system according to claim 6, wherein said data protection signal generator (535, 536c, 536d, 536e) includes

an oscillator (535a) generating a clock signal,
a second counter (535b) coupled to the oscillator (535a) for counting the clock signal to determine the third predetermined time (T2) in response to the data protect set signal (S541a) and to output a first determination signal,

a third counter (535c) coupled to the oscillator (535a) for counting the clock signal to determine the third predetermined time (T2) in response to the data protect release signal (S541b) and to output a second determination signal,
a second one shot pulse generator (535d) coupled to the second counter (535b) for outputting a second one shot pulse signal (S535d) in response to the first determination signal, and
a third one shot pulse generator (535e) coupled to the third counter (535c) for outputting a third one shot pulse signal (S535e) in response to the second determination signal.

**8.** A data write control system according to claim 7, wherein said data protection signal generator (535, 536c, 536d, 536e) further includes

a first gate circuit (536c) having a first terminal receiving the second one shot pulse signal (S535d), a second input terminal receiving the control signal (CS), and an output terminal, the first gate circuit (536c) passing the second one shot pulse signal (S535d) when the control signal (CS) has the first level,
a second gate circuit (536d) having a first terminal receiving the third one shot pulse signal (S535e), a second input terminal receiving the control signal (CS), and an output terminal, the second gate circuit (536d) passing the third one shot pulse signal (S535e) when the control signal (CS) has the first level, and
a flip flop (536e) coupled to the first gate circuit (536c) and the second gate circuit (536d), the flip flop (536e) outputting the data protection signal (DP) in response to the passed second one shot pulse signal (S536c) and the passed third one shot pulse signal (S536d).

**9.** A data write control system comprising:

a switching circuit (305) selectively coupling to a main power supply (301) or a backup power supply (303) in response to a switching control signal;
a data holding circuit (307) receiving a voltage from the main power supply (301 ) or the backup power supply (303) through said switching circuit (305);
a power supply monitor (320) coupled to switching circuit (305) for producing a control signal (CS) selectively having first and second levels and the switching control signal selectively having first and second levels, the control signal (CS) having the first level when the voltage supplied through said switching circuit (305) is greater than a first predetermined level (Vm1), the control signal (CS) being changed from the first level to the second level when the voltage through said switching circuit (305) becomes lower than the first predetermined level (Vm1) and being changed from the second level to the first level after a first predetermined time (t1) when the voltage through said switching circuit (305) becomes greater than a second predetermined level (Vm2) which is lower than the first predetermined level (Vm1), the switching control signal having the first level when the voltage supplied through said switching circuit (305) is greater than a first predetermined level (Vm2), and having the second level when the voltage through said switching circuit (305) is less than or at the first predetermined level (Vm2);

a processor (330) receiving a voltage from the main power supply (301) or the backup power supply (303) through said switching circuit (305), the processor (330) generating a write control signal ($\overline{WR}$) having an active level and an inactive level; and

a data protection circuit (310) receiving a voltage from the main power supply (301) or the backup power supply (303) through said switching circuit (305), the data protection circuit (310) coupled to said data holding circuit (307), said power supply monitor (320) and said processor (330) for outputting the write control signal ($\overline{WR}$) as the internal write control signal ($\overline{W}$) to said data holding circuit (307) when the control signal (CS) has the first level,

characterized in that

said processor (330) further generates a data protection set release select signal (Sa) having an active level and an inactive level and a write signal (Sb) having an active level and an inactive level,

said data protection circuit (310) internally generates a data protection signal (DP) having a first level and a second level and outputs the write control signal ($\overline{WR}$) as the internal write control signal ($\overline{W}$) when the control signal (CS) has the first level and the data protection signal (DP) has the second level, wherein the data protection signal (DP) is changed from the second level to the first level if both of the data protection set release select signal (Sa) and the write signal (Sb) have the active level, and wherein the data protection signal (DP) is changed from the first level to the second level if

(a) the data protection set release select signal (Sa) has the inactive level and the write signal (Sb) has the active level the second predetermined time (T1) after the level of the control signal (CS) is changed from the second level to the first level, and if (b) the third predetermined time (T2) after the condition (a) is met and the control signal (CS) has the first level.

**Patentansprüche**

1. Datenschreibsteuersystem, das folgendes aufweist:

eine Umschaltschaltung (305), die in Antwort auf ein Umschaltsteuersignal selektiv mit einer Hauptenergieversorgung (301) oder einer Reserve-Energieversorgung (303) koppelt; eine Datenhalteschaltung (307), die eine Spannung von der Hauptenergieversorgung (301) oder der Reserve-Energieversorgung (303) durch die Umschaltschaltung (305) empfängt; einen Energieversorgungsmonitor (320), der mit der Umschaltschaltung (305) gekoppelt ist, zum Erzeugen eines Steuersignals (CS) selektiv mit einem ersten und einem zweiten Pegel und eines Umschaltsteuersignals selektiv mit einem ersten und einem zweiten Pegel, wobei das Steuersignal (CS) den ersten Pegel hat, wenn die durch die Umschaltschaltung (305) zugeführte Spannung größer als ein erster vorbestimmter Pegel (Vm1) ist, wobei das Steuersignal (CS) vom ersten Pegel zum zweiten Pegel geändert wird, wenn die Spannung durch die Umschaltschaltung (305) kleiner als der erste vorbestimmte Pegel (Vm1) wird, und nach einer vorbestimmten Zeit (t1) vom zweiten Pegel zum ersten Pegel geändert wird, wenn die Spannung durch die Umschaltschaltung (305) größer als ein zweiter vorbestimmter Pegel (Vm2) wird, der kleiner als der erste vorbestimmte Pegel (Vm1) ist, wobei das Umschaltsteuersignal den ersten Pegel hat, wenn die durch die Umschaltschaltung (305) zugeführte Spannung größer als ein erster vorbestimmter Pegel (Vm2) ist, und den zweiten Pegel hat, wenn die Spannung durch die Umschaltschaltung (305) kleiner als oder gleich wie der erste vorbestimmte Pegel (Vm2) ist; einen Prozessor (330), der eine Spannung von der Hauptenergieversorgung (301) oder der Reserve-Energieversorgung (303) durch die Umschaltschaltung (305) empfängt, wobei der Prozessor (330) ein Schreibsteuersignal ($\overline{WR}$) mit einem aktiven Pegel und einem inaktiven Pegel erzeugt; und eine Datenschutzschaltung (310), die eine Spannung von der Hauptenergieversorgung (301) oder der Reserve-Energieversorgung (303) durch die Umschaltschaltung (305) empfängt, wobei die Datenschutzschaltung (310) mit der Datenhalteschaltung (307), dem Energieversorgungsmonitor (320) und dem Prozessor (330) gekoppelt ist, um das Schreibsteuersignal ($\overline{WR}$) als das interne Schreibsteuersignal ($\overline{W}$) zur Datenhalteschaltung (307) auszugeben, wenn das Steuersignal (CS) den ersten Pegel hat;

dadurch gekennzeichnet, daß

der Prozessor (330) weiterhin ein Datenschutz-Einstell-Freigabe-Auswahlsignal (Sa) mit einem aktiven Pegel und einem inaktiven Pegel und ein Schreibsignal (Sb) mit einem aktiven Pegel und einem inaktiven Pegel erzeugt, die Datenschutzschaltung (310) intern ein Datenschutzsignal (DP) mit einem ersten Pegel und einem zweiten Pegel erzeugt und das Schreibsteuersignal ($\overline{WR}$) als das interne Schreibsteuersignal ($\overline{W}$) ausgibt, wenn das Steuersignal (CS) den ersten Pegel hat und das Datenschutzsignal (DP) den zweiten Pegel hat, wobei das Datenschutzsignal (DP) vom zweiten Pegel zum ersten Pegel geändert wird, wenn

(a) sowohl das Datenschutz-Einstell-Freigabe-Auswahlsignal (Sa) als auch das Schreibsignal (Sb) den aktiven Pegel für eine zweite vorbestimmte Zeit (T1) haben, nachdem der Pegel des Steuersignals (CS) vom zweiten Pegel zum ersten Pegel geändert ist, und wenn
(b) eine dritte vorbestimmte Zeit (T2), nachdem die Bedingung (a) erfüllt ist, das Steuersignal (CS) den ersten Pegel hat, und wobei das Datenschutzsignal (DP) vom ersten Pegel zum zweiten Pegel geändert wird, wenn
(c) das Datenschutz-Einstell-Freigabe-Auswahlsignal (Sa) den inaktiven Pegel hat und das Schreibsignal (Sb) den aktiven Pegel hat, und zwar für die zweite vorbestimmte Zeit (T1), nachdem der Pegel des Steuersignals (CS) vom zweiten Pegel zum ersten Pegel geändert ist, und wenn
(d) die dritte vorbestimmte Zeit (T2), nachdem die Bedingung (c) erfüllt ist, das Steuersignal (CS) den ersten Pegel hat.

2. Datenschreibsteuersystem nach Anspruch 1, wobei die Datenschutzschaltung (310) einen ersten Zeitgeber (534) enthält, der ein erstes einwertiges Impulssignal (S534) mit einer Impulsbreite entsprechend der zweiten vorbestimmten Zeit (T1) in Antwort auf die Pegeländerung des Steuersignals (CS) ausgibt.

3. Datenschreibsteuersystem nach Anspruch 2, wobei der erste Zeitgeber (534) folgendes enthält:

eine Anstiegsflanken-Erfassungsschaltung (534a), die das Steuersignal (CS) empfängt und ein Erfassungssignal ausgibt, wenn das Steuersignal (CS) vom zweiten Pegel zum ersten Pegel geändert wird, und einen ersten Einwert-Impulsgenerator (534b), der mit der Anstiegsflanken-Erfassungsschaltung (534a) gekoppelt ist, zum Erzeugen des ersten einwertigen Impulssignals (S534) in Antwort auf das Erfassungssignal.

4. Datenschreibsteuersystem nach Anspruch 2, wobei die Datenschutzschaltung (310) weiterhin folgendes enthält: eine Gatterschaltung (536a) mit einem ersten Eingangsanschluß, der das Schreibsignal (Sb) empfängt, einem zweiten Eingangsanschluß, der das erste einwertige Impulssignal (S534) empfängt, und einem Ausgangsanschluß, wobei die Gatterschaltung (536a) das Schreibsignal von ihrem Ausgangsanschluß ausgibt, wenn ihr zweiter Anschluß das erste einwertige Impulssignal (S534) nicht empfängt.

5. Datenschreibsteuersystem nach Anspruch 1, wobei die Datenschutzschaltung (310) folgendes enthält: eine Datenschutz-Einstell-Freigabe-Unterscheidungsschaltung (536b), die das Datenschutz-Einstell-Freigabe-Auswahlsignal (Sa) und das Schreibsignal (Sb) empfängt, und die ein Datenschutz-Einstellsignal (S541a) oder ein Datenschutz-Freigabesignal (S541b) in Antwort auf das Datenschutz-Einstell-Freigabe-Auswahlsignal (Sa) und das Schreibsignal (Sb) ausgibt.

6. Datenschreibsteuersystem nach Anspruch 5, wobei die Datenschutzschaltung (310) weiterhin folgendes enthält: einen Datenschutzsignalgenerator (535, 536c, 536d, 536e) zum Erzeugen des Datenschutzsignals (DP) in Antwort auf das Datenschutz-Einstellsignal (S541a), das Datenschutz-Freigabesignal (S541b) und das Steuersignal (CS).

7. Datenschreibsteuersystem nach Anspruch 6, wobei der Datenschutzsignalgenerator (535, 536c, 536d, 536e) folgendes enthält:

einen Oszillator (535a), der ein Taktsignal erzeugt, einen zweiten Zähler (535b), der mit dem Oszillator (535a) gekoppelt ist, zum Zählen des Taktsignals, um die dritte vorbestimmte Zeit (T2) in Antwort auf das Datenschutz-Einstellsignal (S541a) zu bestimmen und um ein erstes Bestimmungssignal auszugeben,
einen dritten Zähler (535c), der mit dem Oszillator (535a) gekoppelt ist, zum Zählen des Taktsignals, um die dritte vorbestimmte Zeit (T2) in Antwort auf das Datenschutz-Freigabesignal (S541b) zu bestimmen, und um ein zweites Bestimmungssignal auszugeben,
einen zweiten Einwert-Impulsgenerator (535d), der mit dem zweiten Zähler (535b) gekoppelt ist, zum Ausgeben eines zweiten einwertigen Impulssignals (535d) in Antwort auf das erste Bestimmungssignal, und
einen dritten Einwert-Impulsgenerator (535e), der mit dem dritten Zähler (535c) gekoppelt ist, zum Ausgeben eines dritten einwertigen Impulssignals (S535e) in Antwort auf das zweite Bestimmungssignal.

8. Datenschreibsteuersystem nach Anspruch 7, wobei der Datenschutzsignalgenerator (535, 536c, 536d, 536e) weiterhin folgendes enthält:

eine erste Gatterschaltung (536c) mit einem ersten Anschluß, der das zweite einwertige Impulssignal (S535d) empfängt, einem zweiten Eingangsanschluß, der das Steuersignal (CS) empfängt, und einem Ausgangsanschluß, wobei die erste Gatterschaltung (536c) das zweite einwertige Impulssignal (S535d) durchläßt, wenn das Steuersignal (CS) den ersten Pegel hat,
eine zweite Gatterschaltung (536d) mit einem ersten Anschluß, der das dritte einwertige Impulssignal (S535e) empfängt, einem zweiten Eingangsanschluß, der das Steuersignal (CS) empfängt, und einem Ausgangsanschluß, wobei die zweite Gatterschaltung (536d) das dritte einwertige Impulssignal (S535e) durchläßt, wenn das Steuersignal (CS) den ersten Pegel hat, und
ein Flip-Flop (536e), das mit der ersten Gatterschaltung (536c) und der zweiten Gatterschaltung (536d) gekoppelt ist, wobei das Flip-Flop (536e) das Datenschutzsignal (DP) in Antwort auf das durchgelassene zweite einwertige Impulssignal (S536c) und das durchgelassene dritte einwertige Impulssignal (S536d) ausgibt.

9. Datenschreibsteuersystem, das folgendes aufweist:

eine Umschaltschaltung (305), die in Antwort auf ein Umschaltsteuersignal selektiv mit einer Hauptenergieversorgung (301) oder einer Reserve-Energieversorgung (303) koppelt;
eine Datenhalteschaltung (307), die eine Spannung von der Hauptenergieversorgung (301) oder der Reserve-Energieversorgung (303) durch die Umschaltschaltung (305) empfängt;
einen Energieversorgungsmonitor (320), der mit der Umschaltschaltung (305) gekoppelt ist, zum Erzeugen eines Steuersignals (CS) selektiv mit einem ersten und einem zweiten Pegel, und eines Umschaltsteuersignals selektiv mit einem ersten und einem zweiten Pegel, wobei das Steuersignal (CS) den ersten Pegel hat, wenn die durch die Umschaltschaltung (305) zugeführte Spannung größer als ein erster vorbestimmter Pegel (Vm1) ist, wobei das Steuersignal (CS) vom ersten Pegel zum zweiten Pegel geändert wird, wenn die Spannung durch die Umschaltschaltung (305) kleiner als der erste vorbestimmte Pegel (Vm1) wird, und nach einer ersten vorbestimmten Zeit (t1) vom zweiten Pegel zum ersten Pegel geändert wird, wenn die Spannung durch die Umschaltschaltung (305) größer als ein zweiter vorbestimmter Pegel (Vm2) wird, der kleiner als der erste vorbestimmte Pegel (Vm1) ist, wobei das Umschaltsteuersignal den ersten Pegel hat, wenn die durch die Umschaltschaltung (305) zugeführte Spannung größer als ein erster vorbestimmter Pegel (Vm2) ist, und den zweiten Pegel hat, wenn die Spannung durch die Umschaltschaltung (305) kleiner als oder gleich wie der erste vorbestimmte Pegel (Vm2) ist;
einen Prozessor (330), der eine Spannung von der Hauptenergieversorgung (301) oder der Reserve-Energieversorgung (303) durch die Umschaltschaltung (305) empfängt, wobei der Prozessor (330) ein Schreibsteuersignal ($\overline{WR}$) mit einem aktiven Pegel und einem inaktiven Pegel erzeugt; und
eine Datenschutzschaltung (310), die eine Spannung von der Hauptenergieversorgung (301) oder der Reserve-Energieversorgung (303) durch die Umschaltschaltung (305) empfängt, wobei die Datenschutzschaltung (310) mit der Datenhalteschaltung (307), dem Energieversorgungsmonitor (320) und dem Prozessor (330) gekoppelt ist, um das Schreibsteuersignal ($\overline{WR}$) als das interne Schreibsteuersignal ($\overline{W}$) zur Datenhalteschaltung (307) auszugeben, wenn das Steuersignal (CS) den ersten Pegel hat,

dadurch gekennzeichnet, daß

der Prozessor (330) weiterhin ein Datenschutz-Einstell-Freigabe-Auswahlsignal (Sa) mit einem aktiven Pegel und einem inaktiven Pegel und ein Schreibsignal (Sb) mit einem aktiven Pegel und einem inaktiven Pegel erzeugt,

die Datenschutzschaltung (310) intern ein Datenschutzsignal (DP) mit einem ersten Pegel und einem zweiten Pegel erzeugt und das Schreibsteuersignal ($\overline{WR}$) als das interne Schreibsteuersignal ($\overline{W}$) ausgibt, wenn das Steuersignal (CS) den ersten Pegel hat und das Datenschutzsignal (DP) den zweiten Pegel hat, wobei das Datenschutzsignal (DP) vom zweiten Pegel zum ersten Pegel geändert wird, wenn sowohl das Datenschutz-Einstell-Freigabe-Auswahlsignal (Sa) als auch das Schreibsignal (Sb) den aktiven Pegel hat, und wobei das Datenschutzsignal (DP) vom ersten Pegel zum zweiten Pegel geändert wird, wenn

(a) das Datenschutz-Einstell-Freigabe-Auswahlsignal (Sa) den inaktiven Pegel hat und das Schreibsignal (Sb) den aktiven Pegel hat, und zwar für die zweite vorbestimmte Zeit (T1), nachdem der Pegel des Steuersignals (CS) vom zweiten Pegel zum ersten Pegel geändert wird, und wenn
(b) die dritte vorbestimmte Zeit (T2), nachdem die Bedingung (a) erfüllt ist, das Steuersignal (CS) den ersten Pegel hat.

## Revendications

1.  Organe de commande d'écriture de données comprenant :

un circuit de commutation (305) se couplant sélectivement à une alimentation principale (301) ou à une alimentation de secours (303) en réponse à un signal de commande de commutation ;
un circuit de maintien de données (307) recevant une tension de l'alimentation principale (301) ou de l'alimentation de secours (303) par l'intermédiaire dudit circuit de commutation (305) ;
un moniteur d'alimentation (320) couplé au circuit de commutation (305) pour produire un signal de commande (CS) ayant sélectivement un premier et un second niveau, le signal de commande de commutation ayant un premier et un second niveau, le signal de commande (CS) ayant le premier niveau lorsque la tension fournie par ledit circuit de commutation (305) est supérieure à un premier niveau prédéterminé (Vm1), le signal de commande (CS) passant du premier niveau au second niveau lorsque la tension passant par ledit circuit de commutation (305) devient inférieure au premier niveau prédéterminé (Vm1) et passant du second niveau au premier niveau après un premier temps prédéterminé (t1) lorsque la tension passant par ledit circuit de commutation (305) devient supérieure à un second niveau prédéterminé (Vm2) qui est inférieur au premier niveau prédéterminé (Vm1), le signal de commande de commutation étant au premier niveau lorsque la tension passant par ledit circuit de commutation (305) est supérieure à un premier niveau prédéterminé (Vm2) et au second niveau lorsque la tension passant par ledit circuit de commutation (305) est inférieure ou égale au premier niveau prédéterminé (Vm2) ;
un processeur (330) recevant une tension de l'alimentation principale (301) ou de l'alimentation de secours (303) passant par ledit circuit de commutation (305), le processeur (330) générant un signal de commande d'écriture ($\overline{WR}$) ayant un niveau actif et un niveau inactif ; et
un circuit de protection de données (310) recevant une tension de l'alimentation principale (301) ou de l'alimentation de secours (303) passant par ledit circuit de commutation (305), le circuit de protection de données (310) couplé audit circuit de maintien de données (307), ledit moniteur d'alimentation (320) et ledit processeur (330), pour délivrer le signal de commande d'écriture ($\overline{WR}$) comme signal de commande d'écriture interne ($\overline{W}$) audit circuit de maintien de données (307) lorsque le signal de commande (CS) est au premier niveau ;

caractérisé en ce que

ledit processeur (330) génère, en outre, un signal de sélection d'établissement/de suppression de protection de données (Sa) ayant un niveau actif et un niveau inactif et un signal d'écriture (Sb) ayant un niveau actif et un niveau inactif,
ledit circuit de protection de données (310) génère, en interne, un signal de protection de données (DP) ayant un premier niveau et un second niveau et délivre le signal de commande d'écriture ($\overline{WR}$) comme signal de commande d'écriture interne ($\overline{W}$) lorsque le signal de commande (CS) est au premier niveau et le signal de protection de données (DP) au second niveau, dans lequel le signal de protection de données (DP) passe du second niveau au premier niveau si

(a) le signal de sélection d'établissement/de suppression de protection de données (Sa) ainsi que le signal d'écriture (Sb) sont au niveau actif dans un second temps prédéterminé (T1) après que le niveau du signal de commande (CS) est passé du second niveau au premier niveau, et si
(b) au troisième temps prédéterminé (T2) après satisfaction de la condition (a), le signal de commande (CS) est au premier niveau, et dans lequel le signal de protection de données (DP) passe du premier niveau au second niveau si

(c) le signal de sélection d'établissement/ de suppression de protection de données (Sa) est au niveau inactif et le signal d'écriture (Sb) est au niveau actif au second temps prédéterminé (T1) après passage du signal de commande (CS) du second niveau au premier niveau, et si

(d) au troisième temps prédéterminé (T2) après satisfaction de la condition (c), le signal de commande (CS) est au premier niveau.

2. Organe de commande d'écriture de données selon la revendication 1, dans lequel ledit circuit de protection de données (310) inclut un premier temporisateur (534) délivrant un premier signal impulsionnel monostable (S534) dont la durée d'impulsion correspond au second temps prédéterminé (T1) en réponse au changement de niveau du signal de commande (CS).

3. Organe de commande d'écriture de données selon la revendication 2, dans lequel le premier temporisateur (534) inclut

un circuit de détection de front de montée (534a) recevant le signal de commande (CS) et délivrant un signal de détection lorsque le signal de commande (CS) passe du second niveau au premier niveau, et

un premier générateur d'impulsion monostable (534b) couplé au circuit de détection de front de montée (534a) pour générer le premier signal impulsionnel monostable (S534) en réponse au signal de détection.

4. Organe de commande d'écriture de données selon la revendication 2, dans lequel ledit circuit de protection de données (310) inclut, en outre, un circuit de porte (536a) ayant une première borne d'entrée recevant le signal d'écriture (Sb), une seconde borne d'entrée recevant le premier signal impulsionnel monostable (S534) et une borne de sortie, le circuit de porte (536a) délivrant le signal d'écriture provenant de la borne de sortie lorsque sa seconde borne ne reçoit pas le premier signal impulsionnel monostable (S534).

5. Organe de commande d'écriture de données selon la revendication 1, dans lequel ledit circuit de protection de données (310) inclut un circuit de discrimination d'établissement/de suppression de protection de données (536b) recevant le signal de sélection d'établissement/de suppression de protection de données (Sa) et le signal d'écriture (Sb) et délivrant un signal d'établissement de protection de données (S541a) ou un signal de suppression de protection de données (S541b) en réponse au signal de sélection d'établissement/de suppression de protection de données (Sa) et au signal d'écriture (Sb).

6. Organe de commande d'écriture de données selon la revendication 5, dans lequel ledit circuit de protection de données (310) inclut, en outre, un générateur de signal de protection de données (535, 536c, 536d, 536e) pour générer le signal de protection de données (DP) en réponse au signal d'établissement de protection de données (S541a), au signal de suppression de protection de données (S541b) et au signal de commande (CS).

7. Organe de commande d'écriture de données selon la revendication 6, dans lequel ledit générateur de signal de protection de données (535, 536c, 536d, 536e) inclut

un oscillateur (535a) générant un signal d'horloge

un second compteur (535b) couplé à l'oscillateur, (535a) pour compter le signal d'horloge pour déterminer le troisième temps prédéterminé (T2) en réponse au signal d'établissement de protection de données (S541a) et pour délivrer un premier signal de détermination,

un troisième compteur (535c) couplé à l'oscillateur (535a) pour compter le signal d'horloge pour déterminer le troisième temps prédéterminé (T2) en réponse au signal de suppression de protection de données (S541b) et pour délivrer un second signal de détermination,

un second générateur d'impulsion monostable (535d) couplé au second compteur (535b) pour délivrer un second signal impulsionnel monostable (S535d) en réponse au premier signal de détermination, et

un troisième générateur d'impulsion monostable (535e) couplé au troisième compteur (535c) pour délivrer un troisième signal impulsionnel monostable (S535e) en réponse au second signal de détermination.

8. Organe de commande d'écriture de données selon la revendication 7, dans lequel ledit générateur de signal de protection de données (535, 536c, 536d, 536e) inclut, en outre,

un premier circuit de porte (536c) ayant une première borne recevant le second signal impulsionnel monostable (S535d), une seconde borne d'entrée recevant le signal de commande (CS) et une borne de sortie, le premier circuit de porte (536c) passant le second signal impulsionnel monostable (S535d) lorsque le signal de commande (CS) est au premier niveau,

un second circuit de porte (536d) ayant une première borne recevant le troisième signal impulsionnel monostable (S535e), une seconde borne d'entrée recevant le signal de commande (CS) et une borne de sortie, le second circuit de porte (536d) passant le troisième signal impulsionnel monostable (S535e) lorsque le signal de commande (CS) est au premier niveau, et

une bascule (536e) couplée au premier circuit de porte (536c) et au second circuit de porte (536d), la bascule (536e) délivrant le signal de protection de données (DP) en réponse au second signal impulsionnel monostable transmis (S536c) et au troisième signal impulsionnel monostable transmis (S536d).

9. Organe de commande d'écriture de données constitué par :

un circuit de commutation (305) se couplant sélectivement à une alimentation principale (301) ou à une alimentation de secours (303) en réponse à un signal de commande de commutation ;

un circuit de maintien de données (307) recevant une tension de l'alimentation principale (301) ou de l'alimentation de secours (303) par ledit circuit de commutation (305) ;

un moniteur d'alimentation (320) couplé au circuit de commutation (305) pour produire un signal de commande (CS) ayant sélectivement un premier et un second niveaux et le signal de commande de commutation ayant sélectivement un premier et un second niveaux, le signal de commande (CS) ayant le premier niveau lorsque la tension fournie par ledit circuit de commutation (305) est supérieure à un premier niveau prédéterminé (Vm1), le signal de commande (CS) passant du premier niveau au second niveau lorsque la tension passant par ledit circuit de commutation (305) devient inférieure au premier niveau prédéterminé (Vm1) et passant du second niveau au premier niveau à l'issue d'un premier temps prédéterminé (t1) lorsque la tension passant par ledit circuit de commutation (305) devient supérieure à un second niveau prédéterminé (Vm2) qui est inférieur au premier niveau prédéterminé (Vm1), le signal de commande de commutation ayant le premier niveau lorsque la tension fournie par ledit circuit de commutation (305) est supérieure à un premier niveau prédéterminé (Vm2) et ayant le second niveau lorsque la tension passant par ledit circuit de commutation (305) est inférieure ou égale au premier niveau prédéterminé (Vm2) ;

un processeur (330) recevant une tension de l'alimentation principale (301) ou de l'alimentation de secours (303) par ledit circuit de commutation (305), le processeur (330) générant un signal de commande d'écriture ($\overline{WR}$) ayant un niveau actif et un niveau inactif ; et

un circuit de protection de données (310) recevant une tension de l'alimentation principale (301) ou de l'alimentation de secours (303) par ledit circuit de commutation (305), le circuit de protection de données (310) couplé audit circuit de maintien de données (307), audit moniteur d'alimentation (320) et audit processeur (330), pour délivrer le signal de commande d'écriture (WR) comme signal de commande d'écriture interne ($\overline{W}$) audit circuit de maintien de données (307) lorsque le signal de commande (CS) est au premier niveau,

caractérisé en ce que

ledit processeur (330) génère, en outre, un signal de sélection d'établissement/de suppression de protection de données (Sa) ayant un niveau actif et un niveau inactif et un signal d'écriture (Sb) ayant un niveau actif et un niveau inactif,

ledit circuit de protection de données (310) génère, en interne, un signal de protection de données (DP) ayant un premier niveau et un second niveau et délivre le signal de commande d'écriture ($\overline{WR}$) comme signal de commande d'écriture interne ($\overline{W}$) lorsque le signal de commande (CS) est au premier niveau et le signal de protection de données (DP) est au second niveau, dans lequel le signal de protection de données (DP) passe du second niveau au premier niveau si à la fois le signal de sélection d'établissement/de suppression de protection de données (Sa) et le signal d'écriture (Sb) sont au niveau actif, et dans lequel le signal de protection de données (DP) passe du premier niveau au second niveau si

(a) le signal de sélection d'établissement/ de suppression de protection de données (Sa) est au niveau inactif et le signal d'écriture (Sb) est au niveau actif au second temps prédéterminé (Tl) après que le niveau du signal de commande (CS) est passé du second niveau au premier niveau, et si

(b) au troisième temps prédéterminé (T2) après satisfaction de la condition (a), le signal de commande (CS) est au premier niveau.

FIG.1

FIG. 2

VOLTAGE OF MAIN
POWER SUPPLY 51    Vm

$Vm_1$

$Vm_2$    $Vm_2$

VOLTAGE OF OUTPUT
OF SELECTOR
SWITCH 53    Vm

$Vm_2$    $Vm_2$

Vb

CS    H

L

t1

FIG. 3

FIG.4

FIG. 5

EP 0 406 442 B1

FIG. 6(a)

FIG. 6(b)

EP 0 406 442 B1

EP 0 406 442 B1

```
                    ┌──────────┐
                    │  START   │
                    └────┬─────┘
                         │          ╱701
         SET        ◇────┴────◇
    ┌──────────────< SET OR RELEASE >
    │               ◇─────────◇
    │                    │
    │                    │ RELEASE   705
    │               ◇────┴────◇      ╱
    │               <  TIME T1? >─────────── YES ──────┐
    │               ◇─────────◇                        │
    │                    │ NO                           │
    │          ┌─────────┴─────────┐                    │
    │          │ SECOND TIMER      │                    │
    │          │ MEANS STARTS      │  707               │
    │          │ TO COUNT TIME T2  │                    │
    │          └─────────┬─────────┘                    │
    │                    │            709               │
    │               ◇────┴────◇       ╱                 │
    │               <  CS="H"?  >──── NO ──────────┐    │
    │               ◇─────────◇                    │    │
    │                    │ YES                      │    │
┌───┴──────┐    ┌────────┴───────┐    ┌────────────┴──┐ │
│ SET DATA │    │ RELEASE DATA   │    │ DATA PROTECTION│ │
│PROTECTION│703 │ PROTECTION     │713 │ SIGNAL DP IS NOT│711
│ SIGNAL DP│    │ SIGNAL DP      │    │ RELEASED       │ │
└───┬──────┘    └────────┬───────┘    └────────────┬──┘ │
    │                    │                          │    │
    └────────────────────┴──────────────────────────┴────┘
                         │
                    ┌────┴─────┐
                    │   END    │
                    └──────────┘
```

FIG. 7

FIG.8

START

DATA PROTECTION
SET RELEASE
INSTRUCTION — 901

902

CS="H"? ──── PROCEED TO STEP 401
OF FIG. 4 OR STEP
701 OF FIG. 7

YES

NO

SET RELEASE OF
DATA PROTECTION
SIGNAL DP IS — 903
NOT EFFECTED

END

FIG. 9